# EUROPEAN PATENT SPECIFICATION

(11) **EP 4 011 071 B1**
(45) Date of publication and mention of the grant of the patent: **11.11.2026**
(21) Application number: 21788018.6
(22) Date of filing: 13.04.2021
(51) Int. Cl.: G06N 3/082, G06N 3/04, G06N 3/084, G06N 3/0464, G06N 3/0495, H03M 7/30, H04N 19/117

(54) **NEURAL NETWORK MODEL COMPRESSION**
KOMPRESSION EINES NEURONALEN NETZMODELLS
COMPRESSION DE MODÈLE DE RÉSEAU NEURONAL

(30) Priority: 16.04.2020 US 202063011122 P; 17.04.2020 US 202063011908 P; 23.06.2020 US 202063042968 P; 15.07.2020 US 202063052368 P; 08.04.2021 US 202117225486
(43) Date of publication of application: 15.06.2022
(73) Proprietor: Tencent America LLC, Palo Alto, California 94306 (US)
(72) Inventor: WANG, Wei, Palo Alto, California 94306 (US); JIANG, Wei, Palo Alto, California 94306 (US); LIU, Shan, Palo Alto, California 94306 (US)
(74) Representative: Gunzelmann, Rainer
(86) International application number: PCT/US2021/026995
(87) International publication number: WO 2021/211522

(56) References cited:
- WO-A1-2019/185883
- KR-A- 20190 010 607
- US-A1- 2018 046 896
- US-A1- 2018 249 158
- "Description of Core Experiments on Compression of Neural Networks for Multimedia Content Description and Analysis", no. n18991, 3 February 2020 (2020-02-03), XP030224411, Retrieved from the Internet <URL:http://phenix.int-evry.fr/mpeg/doc_end_user/documents/129_Brussels/wg11/w18991.zip> [retrieved on 20200203]
- HAASE (FRAUNHOFER) P ET AL: "[NNR] CE2-related: Dependent scalar quantization for neural network parameter approximation", no. m52358, 8 January 2020 (2020-01-08), XP030225001, Retrieved from the Internet <URL:http://phenix.int-evry.fr/mpeg/doc_end_user/documents/129_Brussels/wg11/m52358-v1-m52358.zip> [retrieved on 20200108]
- WIEDEMANN S ET AL: "Response to the Call for Proposals on Neural Network Compression: End-to-end processing pipeline for highly compressible neural networks", no. m47698, 28 March 2019 (2019-03-28), XP030211877, Retrieved from the Internet <URL:http://phenix.int-evry.fr/mpeg/doc_end_user/documents/126_Geneva/wg11/m47698-v2-m47698-v2.zip> [retrieved on 20190328]

## Description

This present disclosure claims the priority to U.S. Patent Application No. 17/225,486, "Neural Network Model Compression" filed on April 8, 2021, which claims priority to U.S. Provisional Application No. 63/011,122, "Dependent Quantization Enabling Flag for Neural Network Model Compression" filed on April 16, 2020, U.S. Provisional Application No. 63/011,908, "Sublayer Ordering in Bitstream for Neural Network Model Compression" filed on April 17, 2020, U.S. Provisional Application No. 63/042,968, "Sublayer ordering flag for Neural Network Model Compression" filed on June 23, 2020, and U.S. Provisional Application No. 63/052,368, "Syntax Elements for Neural Network Model Compression with Structured Weight Unification" filed on July 15, 2020.

### TECHNICAL FIELD

The present disclosure describes embodiments generally related to neural network model compression/decompression.

### BACKGROUND

The background description provided herein is for the purpose of generally presenting the context of the disclosure. Work of the presently named inventors, to the extent the work is described in this background section, as well as aspects of the description that may not otherwise qualify as prior art at the time of filing, are neither expressly nor impliedly admitted as prior art against the present disclosure.

Various applications in the fields of computer vision, image recognition, and speech recognition rely on neural networks to achieve performance improvements. A neural network is based on a collection of connected nodes (also referred to as neurons), which loosely model the neurons in a biological brain. The neurons can be organized into multiple layers. Neurons of one layer can connect to neurons of the immediately preceding and immediately following layers.

A connection between two neurons, like the synapses in a biological brain, can transmit a signal from one neuron to the other neuron. A neuron that receives a signal then

processes the signal and can signal other connected neurons. In some examples, to find the output of a neuron, inputs to the neuron are weighted by the weights of the connections from the inputs to the neuron, and the weighted inputs are summed to generate a weighted sum. A bias may be added to the weighted sum. Further, the weighted sum is then passed through an activation function to produce the output.

KR20190010607A discloses a low-power automatic speech recognition device. A decoder comprises a feature extraction circuit for calculating one or more feature vectors; an acoustic model circuit coupled to receive one or more feature vectors from said feature extraction circuit and assign one or more likelihood values to the one or more feature vectors; a memory for storing states of transition of the decoder; and a search circuit for receiving an input from said acoustic model circuit corresponding to the one or more likelihood values based upon the one or more feature vectors, and for choosing states of transition from the memory based on the input from said acoustic model.

### SUMMARY

Aspects of the disclosure provide methods and apparatuses of neural network model compression/decompression. The invention is set out in the appended claims. All embodiments, aspects or examples of the present description are not encompassed by the wording of the claims, except the ones in Section III.2 of the present description.

### BRIEF DESCRIPTION OF THE DRAWINGS

Further features, the nature, and various advantages of the disclosed subject matter will be more apparent from the following detailed description and the accompanying drawings in which:
FIG. 1 shows a block diagram of an electronic device (130) according to an embodiment of the disclosure.
FIG. 2 shows a syntax example of scanning weight coefficients in a weight tensor.
FIG. 3 shows an example of a step size syntax table.
FIG. 4 shows an example for decoding the absolute values of quantized weight coefficients according to some embodiments of the disclosure.
FIG. 5 shows two scalar quantizers according to embodiments of the disclosure.
FIG. 6 shows an example of a local scaling adaptation process.
FIG. 7 shows an overall framework of an iterative retraining/finetuning process.
FIG. 8 shows an example syntax table (800) for unification based parameter reduction.
FIG. 9 shows an example of a syntax structure of a unification performance map (900).
FIG. 10 shows another example syntax table (1000) for unification based parameter reduction.
FIG. 11 shows a flow chart outlining a process (1100) according to an embodiment of the disclosure.
FIG. 12 is a schematic illustration of a computer system in accordance with an embodiment of the disclosure.

### DETAILED DESCRIPTION OF EMBODIMENTS

Aspects of the disclosure provide various techniques for neural network model compression/decompression. The techniques can include parameter quantization method control techniques, sublayer processing order techniques, and weight unification based parameter reduction techniques.

Artificial neural networks can be adopted for a broad range of tasks in multimedia analysis and processing, media coding, data analytics, and many other fields. Success of using artificial neural networks is based on the feasibility of processing much larger and complex neural networks (deep neural networks, DNNs) than in the past, and the availability of large-scale training data sets. As a consequence, trained neural networks can contain a large number of model parameters, resulting in a quite large size (e.g., several hundred MBs). The model parameters can include coefficients of the trained neural networks such as weights, biases, scaling factors, batch-normalization (batchnorm) parameters, or the like. Those model parameters can be organized into model parameter tensors. A model parameter tensor is used to refer to a multidimensional structure (e.g., array or matrix) that groups related model parameters of a neural network together. For example, the coefficients of a layer in a neural network, when available, can be grouped into a weight tensor, a bias tensor, a scaling factor tensor, a batchnorm tensor, or the like.

Many applications require the deployment of a particular trained network instance, potentially to a larger number of devices, which may have limitations in terms of processing power and memory (e.g., mobile devices or smart cameras) and also in terms of communication bandwidth. Those applications can benefit from neural network compression/decompression techniques disclosed herein.

### I. Neural Network based Devices and Applications

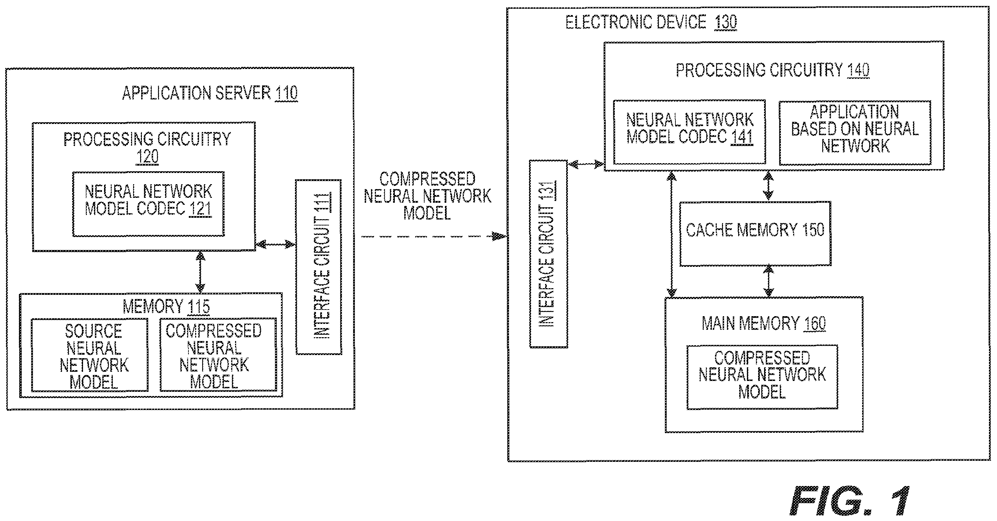

FIG. 1 shows a block diagram of an electronic device (130) according to an embodiment of the disclosure. The electronic device (130) can be configured to run neural network based applications. In some embodiments, the electronic device (130) receives and stores a compressed (encoded) neural network model (e.g., a compressed representation of a neural network in form of a bitstream). The electronic device (130) can decompress (or decode) the compressed neural network model to restore the neural network model, and can run an application that is based on the neural network model. In some embodiments, the compressed neural network model is provided from a server, such as an application server (110).

In the FIG. 1 example, the application server (110) includes processing circuitry (120), a memory (115), and interface circuitry (111) coupled together. In some examples, a neural network is suitably generated, trained, or updated. The neural network can be stored in the memory (115) as a source neural network model. The processing circuitry (120) includes a neural network model codec (121). The neural network model codec (121) includes an encoder that can compress the source neural network model and generate a compressed neural network model (compressed representation of the neural network). In some examples, the compressed neural network model is in the form of a bitstream. The compressed neural network model can be stored in the memory (115). The application server (110) can provide the compressed neural network model to other devices, such as the electronic device (130), via the interface circuit (111) in the form of a bitstream.

It is noted that the electronic device (130) can be any suitable device, such as a smartphone, a camera, a tablet computer, a laptop computer, a desktop computer, a gaming headset, and the like.

In the FIG. 1 example, the electronic device (130) includes processing circuitry (140), cache memory (150), main memory (160), and interface circuit (131) coupled together. In some examples, the compressed neural network model is received by the electronic device (130) via the interface circuit (131), for example in the form of a bitstream. The compressed neural network model is stored in the main memory (160).

The processing circuitry (140) includes any suitable processing hardware, such as central processing units (CPUs), graphics processing units (GPUs), and the like. The processing circuitry (140) includes suitable components to execute applications based on neural networks, and includes suitable components configured as a neural network model codec (141). The neural network model codec (141) includes a decoder that can decode, for example, the compressed neural network model received from the application server (110). In an example, the processing circuitry (140) includes a single chip (e.g., integrated circuit) with one or more processors disposed on the single chip. In another example, the processing circuitry (140) includes multiple chips, and each chip can include one or more processors.

In some embodiments, the main memory (160) has a relatively large storage space and can store various information, such as software codes, media data (e.g., video, audio, image, etc.), compressed neural network models, and the like. The cache memory (150) has relatively small storage space, but a much faster access speed compared to the main memory (160). In some examples, the main memory (160) can include hard disc drives, solid state drives, and the like, and the cache memory (150) can include static random access memory (SRAM), and the like. In an example, the cache memory (150) can be on-chip memory that is disposed on, for example, a processor chip. In another example, the cache memory (150) can be off-chip memory that is disposed on one or more memory chips that are separate from the processor chips. Generally, on-chip memory has faster access speed than off-chip memory.

In some embodiments, when the processing circuitry (140) executes an application that uses a neural network model, the neural network model codec (141) can decompress the compressed neural network model to restore the neural network model. In some examples, the cache memory (150) is large enough, thus the restored neural network model can be buffered in the cache memory (150). Then, the processing circuitry (140) can access the cache memory (150) to use the restored neural network model in the application. In another example, the cache memory (150) has limited memory space (e.g., on-chip memory), the compressed neural network model can be decompressed layer by layer, or block by block, and the cache memory (150) can buffer the restored neural network model layer by layer or block by block.

It is noted that the neural network model codec (121) and the neural network model codec (141) can be implemented by any suitable techniques. In some embodiments, encoder and/or decoder can be implemented by integrated circuits. In some embodiments, encoder and decoder can be implemented as one or more processors executing a program that is stored in a non-transitory computer-readable medium. The neural network model codec (121) and the neural network model codec (141) can be implemented according to the encoding and decoding features described below.

The present disclosure provides techniques for neural network representation (NNR) that can be used to encode and decode neural network models, such as deep neural network (DNN) models, to save both storage and computation. Deep Neural Network (DNN) can be used in a large range of video applications, such as semantic classification, target detection/recognition, target tracking, video quality enhancement, and the like.

A neural network (or an artificial neural network) generally includes multiple layers between the input layer and the output layer. In some examples, a layer in the neural network corresponds to the mathematical manipulation to turn the inputs of the layer into the outputs of the layer. The mathematical manipulation can be a linear relationship or a non-linear relationship. The neural network can move through the layers to calculate the probability of each output. Each mathematical manipulation as such is considered a layer, and complex DNN can have many layers. In some examples, mathematical manipulation of a layer can be represented by one or more tensors (e.g., weight tensor, bias tensor, scaling factor tensor batchnorm tensor, or the like).

### II. Dependent Quantization Enablement

### 1. Scan Order

Various techniques, such as scan order techniques, quantization techniques, entropy coding techniques, and the like can be used in the encoding/decoding of neural network models.

In some examples of the scan order techniques, the dimensions of a weight tensor are more than two (such as four in a convolution layer) and the weight tensor can be reshaped to a two-dimension tensor. No reshape is performed if the dimensions of a weight tensor are no more than two (such as a fully connected layer or bias layer) in an example.

To encode the weight tensor, weight coefficients in the weight tensor are scanned according to a certain order. In some examples, the weight coefficients in the weight tensor can be scanned in a row-first manner from the left to the right for each row and from the top row to the bottom row, for example.

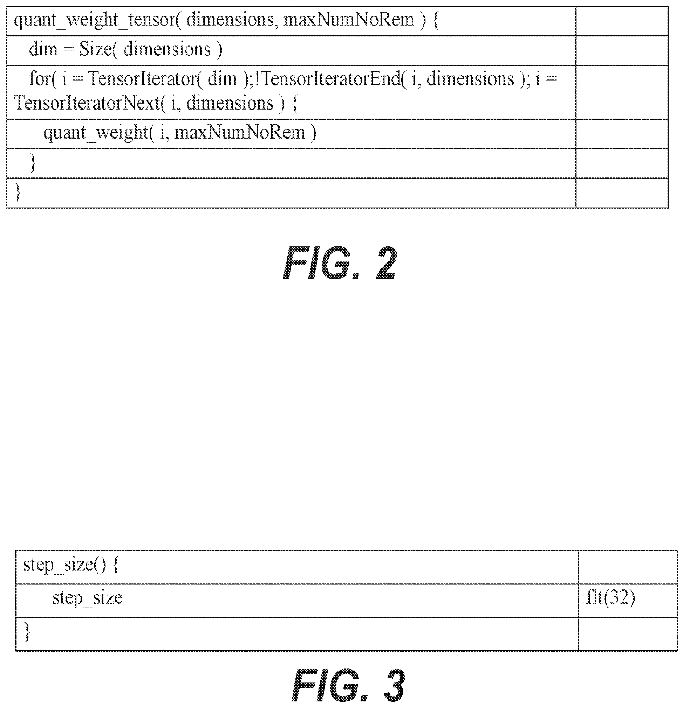

FIG. 2 shows a syntax example of scanning weight coefficients in a weight tensor.

### 2. Quantization

**In** some examples, nearest neighbour quantization is applied in a uniform way to each weight coefficient in the weight matrices. Such a quantization method is referred to as a uniform quantization method. For example, a step size is suitably determined and is included in the bitstream. In an example, the step size is defined as a 32-bit floating number and coded in the bitstream. Thus, when the decoder decodes from the bitstream the step size and an integer number corresponding to a weight coefficient, the decoder can reconstruct the weight coefficient as a multiplication of the integer number and the step size.

FIG. 3 shows an example of a step size syntax table. A syntax element, step_size, indicates a quantized step size.

### 3. Entropy Coding

To encode the quantized weight coefficients, entropy coding techniques can be used. In some embodiments, an absolute value of the quantized weight coefficient is coded in a sequence that includes a unary sequence that may be followed by a fixed length sequence.

**In** some examples, the distribution of the weight coefficients in a layer generally follows Gaussian distribution, and the percentage of weight coefficients with a large value is very small, but the maximum value of the weight coefficients can be very large. In some embodiments, very smaller values can be coded using unary coding, and the larger values can be coded based on Golomb coding. For example, an integer parameter that is referred to as maxNumNoRem is used to indicate the maximum number when Golomb coding is not used. When a quantized weight coefficient is not greater than (e.g., is equal or smaller than) maxNumNoRem, the quantized weight coefficient can be coded by the unary coding. When the quantized weight coefficient is greater than maxNumNoRem, a portion of the quantized weigh coefficient equal to maxNumNoRem is coded by unary coding, and the remainder of the quantized weight coefficient is coded by Golomb coding. Thus, the unary sequence includes a first portion of the unary coding and a second portion of bits for coding the exponential Golomb remainder bits.

**In** some embodiments, a quantized weight coefficient can be coded by the following two steps.

**In** a first step, a binary syntax element sig_flag is encoded for the quantized weight coefficient. The binary syntax element sig_flag specifies whether the quantized weight coefficient is equal to zero. If the sig_flag is equal to one (indicates that the quantized weight coefficient is not equal to zero), a binary syntax element sign_flag is further encoded. The binary syntax element sign_flag indicates whether the quantized weight coefficient is positive or negative.

In the second step, the absolute value of the quantized weight coefficient can be coded into a sequence that includes a unary sequence that may be followed by a fixed length sequence. When the absolute value of the quantized weight coefficient is equal to or smaller than maxNumNoRem, the sequence includes unary coding of the absolute value of the quantized weight coefficient. When the absolute value of the quantized weight coefficient is greater than maxNumNoRem, the unary sequence can include a first part for coding maxNumNoRem using unary coding, and a second part for coding the exponential Golomb remainder bits, and the fixed length sequence is for coding a fixed length remainder.

In some examples, a unary coding is applied first. For example, a variable, such as j, is initialized with 0, and another variable X is set to j+1. A syntax element abs_level_greater_X is encoded. In an example, when the absolute value of the quantized weight level is greater than the variable X, abs_level_greater_X is set to 1, the unary encoding continues; otherwise, abs_level_greater_X is set to 0, and unary encoding is done. When abs_level_greater_X is equal to 1, and the variable j is smaller than maxNumNoRem, the variable j is increased by 1 and the variable X is also increased by 1. Then, a further syntax element abs_level_greater_X is encoded. The process continues until abs_level_greater_X is equal to 0 or the variable j is equal to maxNumNoRem. When the variable j is equal to maxNumNoRem, the encoded bits are the first part of the unary sequence.

When abs_level_greater_X is equal to 1 and j is equal to maxNumNoRem, the coding continues with Golomb coding. Specifically, the variable j is reset to 0, and X is set to 1<<j. A unary coding remainder can be calculated as the absolute value of the quantized weight coefficient subtracting maxNumNoRem. A syntax element abs_level_greater_than X is encoded. In an example, when the unary coding remainder is greater than the variable X, abs_level_greater_X is set to 1; otherwise, abs_level_greater_X is set to 0. If the abs_level_greater_X is equal to 1, the variable j is increased by 1, and 1 << j is added to X and a further abs_level_greater_X is encoded. The procedure is continued until an abs_level_greater_X is equal to 0, thus the second part of the unary sequence is encoded. When an abs_level_greater_X is equal to 0, the unary coding remainder can be one of the values (X, X - 1, ... X - ( 1 < < j ) + 1 ). A code of length j can be used to code an index that points to one value in (X, X - 1, ... X - ( 1 << j) + 1 ), the code can be referred to as a fixed length remainder.

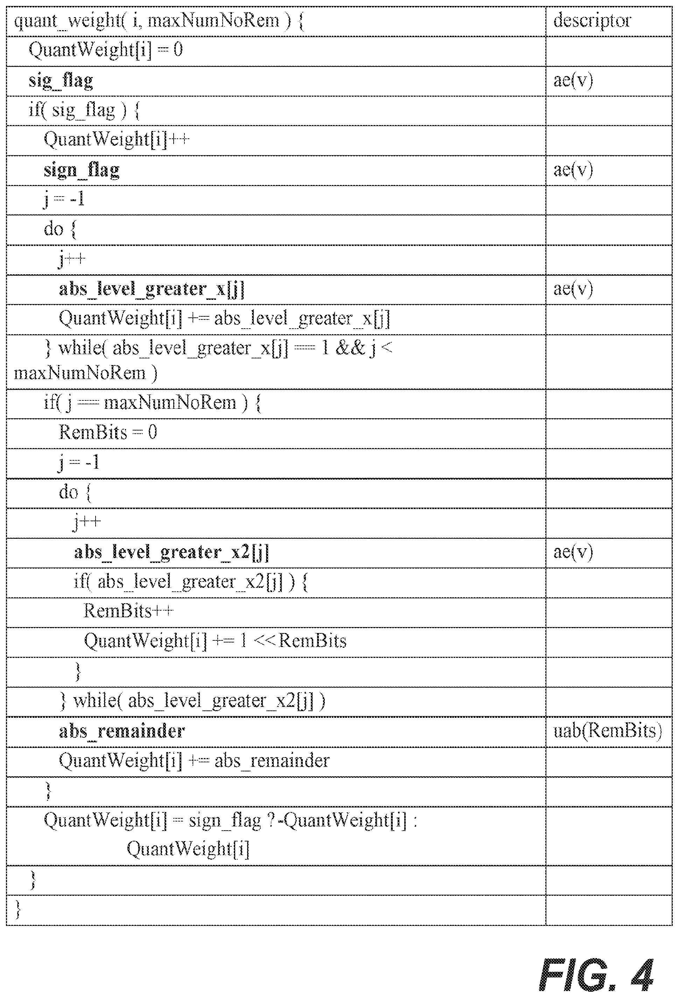

FIG. 4 shows an example for decoding the absolute values of quantized weight coefficients according to some embodiments of the disclosure. In the FIG. 4 example, QuantWeight[i] denotes the quantized weight coefficient at the ith position in an array; sig_flag specifies whether the quantized weight coefficient QuantWeight[i] is nonzero (e.g., sig_flag being 0 indicates that QuantWeight[i] is zero); sign_flag specifies whether the quantized weight coefficient QuantWeight[i] is positive or negative (e.g., sign_flag being 1 indicates that QuantWeight[i] is negative); abs_level_greater_x[j] indicates whether the absolute level of QuantWeight[i] is greater j + 1 (e.g., first part of the unary sequence); abs_level_greater_x2[j] comprises the unary part of the exponential Golomb remainder (e.g., second part of the unary sequence); and abs_remainder indicates a fixed length remainder.

According to an aspect of the disclosure, a context modeling approach can be used in the coding of the three flags sig_flag, sign_flag, and abs_level_greater_X. Thus, flags with similar statistical behavior can be associated with the same context model, so that the probability estimator (inside of the context model) can adapt to the underlying statistics.

In an example, the context modeling approach uses three context models for the sig_flag, depending on whether the neighboring quantized weight coefficient to the left is zero, smaller, or larger than zero.

In another example, the context model approach uses three other context models for the sign_flag, depending on whether the neighboring quantized weight coefficient to the left is zero, smaller, or larger than zero.

In another example, for each of the abs_level_greater_X flags, the context modeling approach uses either one or two separate context models. In an example, when X <= maxNumNoRem, two context models are used depending on the sign_flag. When X > maxNumNoRem, only one context model is used in an example.

### 4. Dependent Quantization

In some embodiments, a dependent scalar quantization method is used for neural network parameter approximation. A related entropy coding method can be used to cooperate with the quantization method. The method introduces dependencies between the quantized parameter values, which reduces the distortion in parameter approximation. Additionally, the dependencies can be exploited in the entropy coding stage.

In dependent quantization, the admissible reconstruction values for a neural network parameter (e.g., weight parameter) depend on the selected quantization indexes for the preceding neural network parameters in reconstruction order. The main effect of the approach is that, in comparison to conventional scalar quantization, the admissible reconstruction vectors (given by all reconstructed neural network parameters of a layer) are packed denser in the N-dimensional vector space (N represents the number of parameters in a layer). That means, for a given average number of admissible reconstruction vectors per N-dimensional unit volume, the average distance (e.g. Mean Squared Error (MSE) or Mean Absolute Error (MAE) distortion) between an input vector and the closest reconstruction vector is reduced (for typical distributions of input vectors).

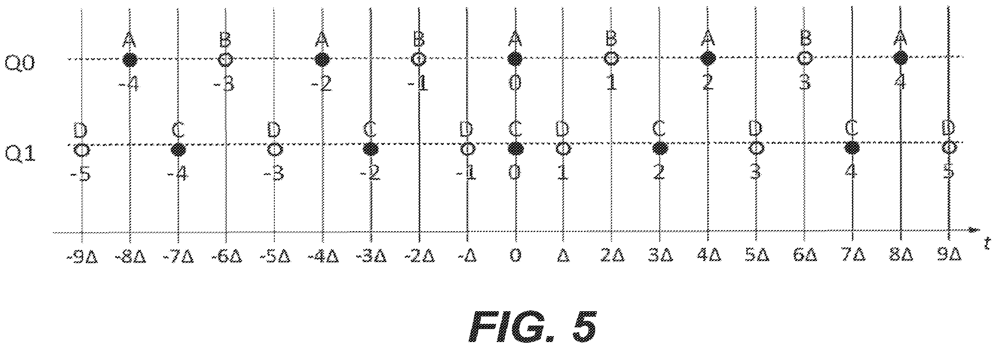

In the dependent quantization process, parameters can be reconstructed in a scanning order (in the same order in which they are entropy decoded), due to the dependencies between the reconstructed values. Then, the method of dependent scalar quantization can be realized by defining two scalar quantizers with different reconstruction levels and defining a process for switching between the two scalar quantizers. Accordingly, for each parameter, there can be two available scalar quantizers as shown in FIG. 5.

FIG. 5 shows the two scalar quantizers used according to embodiments of the disclosure. The first quantizer Q0 maps the neural network parameter levels (numbers from -4 to 4 below the points) to even integer multiples of the quantization step size Δ. The second quantizer Q1 maps the neural network parameter levels (numbers from -5 to 5) to odd integer multiples of the quantization step size Δ or to zero.

For both the quantizers Q0 and Q1, the location of the available reconstruction levels is uniquely specified by the quantization step size Δ. The two scalar quantizers Q0 and Q1 are characterized as follows:
Q0: The reconstruction levels of the first quantizer Q0 are given by the even integer multiples of the quantization step size Δ. When this quantizer is used, a reconstructed neural network parameter *t'*is calculated according to $t ′ = 2 ⋅ k ⋅ Δ ,$ (Eq. 1) where k denotes the associated parameter level (transmitted quantization index).
Q1: The reconstruction levels of the second quantizer Q1 are given by the odd integer multiples of the quantization step size Δ and the reconstruction level equal to zero. The mapping of neural network parameter levels k to reconstructed parameters t' is specified by $t ′ = \left(2⋅k-sgn\left(k\right)\right) ⋅ Δ ,$ (Eq. 2) where sgn(·) denotes the signum function $sgn \left(x\right) = \left\{\begin{matrix}1 & : & x > 0 \\ 0 & : & x = 0 \\ - 1 & : & x < 0\end{matrix}\right. .$ (Eq. 3)

Instead of signaling the used quantizer (Q0 or Q1) for a current weight parameter explicitly in the bitstream, it is determined by the parities of the weight parameter levels that precede the current weight parameter in coding/reconstruction order. The switching between the quantizers is realized via a state machine, which is represented by Table 1. The state has eight possible values (0, 1, 2, 3, 4, 5, 6, 7) and is uniquely determined by the parities of the weight parameter levels preceding the current weight parameter in coding/reconstruction order. For each layer, the state variable is initially set to 0. When a weight parameter is reconstructed, the state is updated afterwards according to Table 1 where k denotes the value of the transform coefficient level. The next state depends on the current state and the parity (k & 1) of the current weight parameter level k. Hence, the state update can be obtained by: $state = sttab \left[state\right] \left[k&1\right]$ (Eq. 4) where sttab represents Table 1.

Table 1 shows a state transition table for determining the scalar quantizer used for the neural network parameters, where k denotes the value of the neural network parameter:

**Table 1**

| current state | next state for | | Quantizer (Q0/Q1) for current parameter |
|---|---|---|---|
| | (k & 1) == 0 | (k & 1) == 1 | |
| 0 | 0 | 2 | 0 |
| 1 | 7 | 5 | 1 |
| 2 | 1 | 3 | 0 |
| 3 | 6 | 4 | 1 |
| 4 | 2 | 0 | 0 |
| 5 | 5 | 7 | 1 |
| 6 | 3 | 1 | 0 |
| 7 | 4 | 6 | 1 |

The state uniquely specifies the scalar quantizer used. If the state value for a current weight parameter is even (0, 2, 4, 6), the scalar quantizer Q0 is used. Otherwise, if the state value is odd (1, 3, 5, 7), scalar quantizer Q1 is used.

### 5. Dependent Quantization Enabling Flags

In dependent quantization, for a given parameter level (transmitted quantization index) k, if quantizer Q0 is used, the reconstructed neural network parameter t' is calculated according to t' = 2 · k · Δ; if quantizer Q1 is used, the reconstructed parameters t' is specified by t' = (2 · k - sgn(k) ) · Δ .

It is known that many current modern high-performance inference engineer use low-bitdepth integers (such as INT8 or INT4) to perform matrix multiplication. However, in some cases, the integer parameter level (transmitted quantization index) k obtained by the dependent quantization procedure is not used by an inference engine directly. The integer parameter level may be dequantized to a floating-number reconstructed parameter value and later used by the inference engine. The floating-number value may not match with the inference engine operating with low-bitdepth integers.

To solve the above problem, in some embodiments, a control mechanism can be employed to turn on or turn off a dependent quantization tool at the encoder side for compression of a neural network. For example, a dependent quantization enabling flag, denoted dq_flag, can be signaled in a bitstream of a compressed neural network model. The flag can indicate whether a dependent quantization method is used for the compression of model parameters of the compressed neural network model.

When the bitstream is received at a decoder, the decoder can determine how to decode the bitstream based on the dependent quantization enabling flag. For example, in response to the dependent quantization enabling flag indicating the dependent quantization method is used for encoding the neural network, the decoder can reconstruct the model parameters of the neural network based on the dependent quantization method. When the dependent quantization enabling flag indicates the dependent quantization method is not used for encoding the neural network, the decoder can proceed to process the bitstream in a different way.

In an example, the dependent quantization enabling flag dq_flag specifies whether the quantization method applied is a dependent scalar quantization method or a uniform quantization method. A dq_flag equal to 0 indicates that the uniform quantization method is used. A dq_flag equal to 1 indicates that the dependent quantization method is used. In an example, when dq_flag is not present in the bitstream, the dq_flag is inferred to be 0. In other examples, a dq_flag equal to 0 may indicate another parameter quantization method other than the uniform quantization method.

In various embodiments, the dq_flag can be signaled in various levels in a bitstream. For example, one or more dependent quantization enabling flags can be signaled at a model level, a layer level, a sublayer level, a 3-dimensional coding unit (CU3D) level, a 3-dimensional coding tree unit (CTU3D) level, or the like. In an example, a dq_flag transmitted in a lower level may override a dq_flag transmitted in a higher level. In this case, different quantization methods may be employed for compression of model parameters at different positions within a structure of a model parameter tensor or in different model parameter tensors.

For example, a neural network may include multiple layers (e.g., convolutional layers or fully-connected layers). A layer may include multiple tensors (e.g., a weight tensor, a bias tensor, a scaling factor tensor, or batchnorm parameter tensors) each corresponding to a sublayer. Accordingly, in one embodiment, a dq_flag is defined at a model header level, so that a dependent quantization procedure can be turned on or off for all layers in the model. In another embodiment, a dq_flag is defined for each layer, so that a dependent quantization procedure can be turned on or off at per layer level. In another embodiment, a dq_flag is defined at sublayer level.

In some examples, a tensor (e.g., weight tensor) may be partitioned into blocks based on a predefined hierarchical structure. In an example, the dimension of a weight tensor is usually 4 for a convolution layer with a layout of [R][S][C][K], 2 for a fully-connected layer with a layout of [C][K], and 1 for a bias and batch normalization layer. Where R/S is a convolution kernel size, C is an input feature size and K is an output feature size. For a convolution layer, the 2D [R][S] dimension can be reshaped to 1D [RS] dimension so that the 4D tensor [R][S][C][K] is reshaped to 3D tensor [RS][C][K]. A fully-connected layer is treated as a special case of 3D tensor with R=S=1.

The 3D tensor [RS][C][K] can be partitioned along [C][K] plane with nonoverlapping smaller blocks referred to as 3D coding tree unit (CTU3D). The CTU3D blocks can be further partitioned into 3D coding unit (CU3D) based on a quadtree structure. Whether to split a node in the quadtree structure can be based on a rate-distortion (RD) based decision. In some embodiments, slice, tile, or other block partition mechanisms may be used in combination with the CTU3D/CU3D partition method for partitioning along a [C][K] plane in a way similar to partitioning in the Versatile Video Coding (VVC) standard.

In an embodiment, when the above CTU3D/CU3D partitioning method is employed, one or more dq_flags can be defined and signaled at different block partition levels (e.g., levels of a CU3D, a CTU3D, a slice, a tile, or the like).

### III. Sublayer Transmission Order in Bitstream

### 1. Scaling Factor Layer, Bias Layer, and Batchnorm Layer

In some embodiments, a local parameter scaling tool can be used to add a local scaling factor to model parameters after quantization has been performed on a layer or sublayer of a neural network. The scaling factor can be adapted or optimized to reduce a loss in prediction performance caused by respective quantization errors.

In an embodiment, a local scaling adaptation (LSA) method is performed using an already quantized neural network as input. For example, the linear components (a.k.a. weights) of the convolutional (conv) and fully-connected (fc) layers of the neural network are expected (but not necessarily) to be quantized. The method then introduces a factor (a.k.a a scaling factor) to the output of the weights of the conv and fc layers. For example, in the case of fc-layers, the factor corresponds to a vector with a same dimension as the number of rows of the weight matrix, which is respectively element-wise multiplied. As for conv layers, a scaling factor per output feature map can be applied to conserve the convolution property.

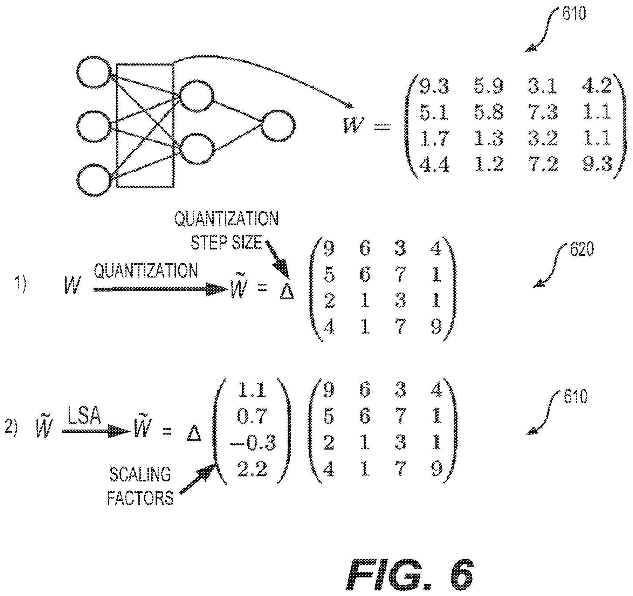

FIG. 6 shows an example of an LSA process. In a first step (620), a weight tensor (610) is quantized using a quantization step size Δ. In a second step, LSA is applied to reduce a prediction loss of the quantization. As shown, a vector including scaling factors [1.1 0.7 -0.3 2.2] is applied.

In some embodiments, a coding method is used to fold a scaling factor with a batchnorm layer (batchnorm folding). This method can be applied if a conv or fc layer is followed by a batch-normalization layer. In this case, the batch-normalization layer can be folded with the conv/fc layer (or a weight tensor in the conv/fc layer) in the following manner: $BN \left(X\right) = \frac{s ⋅ W ∗ X + b - μ}{\sqrt{{σ}^{2} + ϵ}} ⋅ γ + β = α ⋅ W ∗ X + δ$ (Eq. 5) where s denotes a scaling factor in LSA, W denotes a weight tensor, X represent source data, b denotes a bias, γ, σ, µ, and β are batchnorm parameters, $α = s ⋅ γ / \sqrt{{σ}^{2} + ϵ}$ represents a resulting scaling factor, and $δ = \left(b-μ\right) ⋅ γ / \sqrt{{σ}^{2} + ϵ} + β$ represents resulting bias. Hence, α and δ can be signaled in this case instead of signaling s with γ, σ, µ, and β.

In some embodiments, another form of batchnorm folding can be applied if parameters of a model cannot be changed (e.g. when the decoder doesn't support changing the type of parameters) using the following batch norm folding operation (ordered steps) resulting in a set of new batchnorm parameters: $β : = β - μ ⋅ γ ⋅ / \sqrt{{σ}^{2} + ϵ}$ (Eq. 6) $γ : = γ ⋅ \sqrt{1 + ϵ} / \sqrt{{σ}^{2} + ϵ}$ (Eq. 7) ${σ}^{2} : = 1$ (Eq. 8) $μ : = 0$ (Eq. 9)

In this case, σ² and µ contain trivial values. In some examples, the trivial parameters are set to trivial values and not signaled in the bitstream.

In the above described LSA or batchnorm folding examples, the scaling factors, biases, and batchnorm parameters s, b, γ, σ, µ, β, α, δ in Eqs. 5-9, when available in a layer of a neural network model, can each form a sublayer belonging to the respective layer. Parameters of each sublayer can be grouped into a parameter tensor. It is noted that not all of those sublayers/tensors are necessarily present in a bitstream of a compressed neural network. Which sublayers/parameters are present in the bitstream depends on a structure of the neural network and which coding tools (e.g., an LSA method or a particular batchnorm folding method) are used for compression of the neural network.

### 2. Sublayer Ordering in a Bitstream

In an embodiment encompassed by the wording of the claims, during an inference process over a neural network model, an inference engine merges (combines or fuses) multiple tensors, sublayers, or layers whenever possible to decrease computation cost and/or memory bandwidth consumption. For example, a layer in the neural network model may include multiple sublayers. If the tensors of those sublayers are used sequentially to process data resulting from a previous layer or sublayer one by one, intermediate data would be stored to and retrieved from memories for multiple rounds. This would result in extensive memory access as well as matrix computation. Merging the sublayers followed by a one-time processing over source data from a prior layer/sublayer avoids that cost.

For example, when a conv or fc layer is followed by a bias layer, the inference engine will merge the bias layer with the conv or fc layer. When a conv or fc layer is followed by a batch-normalization layer, the inference engine can merge the batch-normalization layer into the conv or fc layer. When the scaling factor is introduced in the conv or fc layer, the inference engine can merge the scaling factor into the batch-normalization layer which can subsequently be merged with the conv or fc layer.

In some embodiments, an inference procedure can be executed in parallel with a decoding procedure in a pipelined manner. For example, a weight tensor in a compressed form in a bitstream can be decoded block by block (e.g., row by row, or CU3D CU3D). The blocks can be output from the decoding procedure sequentially. When a block of the weight tensor is available from the decoding procedure, an inference engine may perform data processing with the weight tensor block on the fly over source data from a previous layer/sublayer. In other words, the inference operation can start without waiting for the whole weigh tensor is decoded and becomes available.

The aforementioned sublayer/layer merge technique cannot be used in combination with the on-the-fly operation based on a partially available weight tensor if the scaling factor, bias and/or batch-normalization sublayer coefficients are placed after the conv or fc (weight tensor) coefficients in the bit-stream.

To facilitate the combination of the on-the-fly operation and the sublayer/tensor merge technique, the sublayers of non-weight coefficients (coefficients other than the conv or fc coefficients (weight coefficients)) in a layer of a neural network are arranged in advance of the sublayer of the conv or fc coefficients (weight coefficients) in a bitstream carrying the compressed representation of the neural network. In this way, the sublayers of non-weight coefficients can have been reconstructed and available while the conv or fc coefficients are being reconstructed. When a part (a block) of the weight tensor becomes available, a merge operation can first be performed over this part using the coefficients of the available non-weight sublayers. The result of the merge operation can be input to an inference engine to process source data on the fly.

The sublayers of coefficients reconstructed before the conv or fc coefficients can include scaling factor coefficients sublayers, bias coefficients sublayers, batch-normalization coefficients layers, or other types of sublayers that can merge with the sublayers of the conv or fc coefficients.

The scaling factor, bias and/or batch-normalization coefficients are arranged in front of conv or fc coefficients in a bit-stream. In one embodiment, if a conv or fc layer is followed by a bias in a neural network model, the bias coefficients can be arranged in front of the conv or fc coefficients in a bitstream. In another embodiment, if a conv or fc layer is followed by a batch-normalization layer, the batch-normalization coefficients can be arranged in front of the conv or fc coefficients in a bitstream. In another embodiment, if a scaling factor is used for a conv or fc layer, the scaling factor can be arranged in front of the conv or fc coefficients in a bitstream. In another embodiment, if a scaling factor is used for a conv or fc layer and the conv or fc layer is followed by a bias and/or a batch-normalization layer, the scaling factor, bias and/or batch-normalization layer can be arranged in front of conv or fc coefficients in the bitstream.

In one embodiment, the aforementioned scaling factor, bias and/or batch-normalization coefficients can be represented using their original values (e.g., without quantization or unquantized) and optionally encoded using any suitable encoding method. In another embodiment, the aforementioned scaling factor, bias and/or batch-normalization coefficients can be represented using their quantized values and optionally encoded using any encoding method.

In one embodiment, if transmission of a model structure of a neural network is separate from a bitstream body carrying a compressed representation of the neural network, a decoder receiving the bitstream body can be configured to analyze the model structure and accordingly adjust or determine a layer or sublayer decoding sequence. For example, when a layer includes a sublayer of weight tensor followed by a batchnorm sublayer, the decoder can determine coefficients of a batchnorm layer are arranged in front of the sublayer of weight tensor in the bitstream body. When a layer includes a sublayer of weight tensor with a scaling factor and a bias, the decoder can determine coefficients of the scaling factor and the bias are arranged in front of the sublayer of weight tensor in the bitstream body.

In another embodiment, if a model structure of a neural network is embedded in a bitstream body carrying a compressed representation of the neural network, a flag can be added, for example, in a conv/fc layer header, to indicate whether the conv/fc layer (the sublayer of a weight tensor) is followed by a batch normalization layer in the neural network. A decoder receiving the bitstream body can accordingly determine or adjust a sublayer/layer decoding sequence.

In another embodiment, if a model structure of a neural network is embedded in a bitstream body of the neural network, a flag can be added, for example, in a conv/fc layer header, to indicate whether a bias or local scaling tensor exists in this conv/fc layer in the neural network. In another embodiment, if structure information of a neural network is embedded in a bitstream body of the neural network, the following 1D tensor of a weight tensor (a conv/fc sublayer) can be inferred as a bias/local scaling tensor in the neural network model based on the structure information.

### IV. Unification Based Model Parameter Reduction

In some embodiments, one or more parameter reduction methods are used to process a neural network model to obtain a compact representation of the neural network. Examples of such methods can include parameter sparsification, parameter pruning, parameter (e.g., weight) unification, and decomposition methods. For example, in a unification process, model parameters can be processed to produce groups of similar parameters. As a result, the entropy of the model parameters can be lowered. In some cases, unification does not eliminate or constrain the weights to be zero.

In some embodiments, learning based approaches are employed to obtain a compact DNN model. The target is to remove unimportant weight coefficients based on the assumption that the smaller the weight coefficients are in value, the less their importance is. In some examples, network pruning methods can be employed to explicitly pursue this goal, and sparsity-promoting regularization terms can be added to the network training target. In some embodiments, after learning a compact network model, the weight coefficients of the network model can be further compressed by quantization followed by entropy coding. Such further compression processes can significantly reduce the storage size of the DNN model, which are essential for model deployment over mobile devices, chips, etc., in some scenarios.

The present disclosure provides a method and related syntax elements for compressing a DNN model using a structured weight unification method as well as for using the compressed DNN model for an inference process. As a result, inference computation performance and compression efficiency can be improved.

### 1. Unification Regularization

An iterative network retraining/refining framework can be used to jointly optimize an original training target and a weight unification loss. The weight unification loss can include a compression rate loss, a unification distortion loss, and a computation speed loss. The learned network weight coefficients can preserve the original target performance, be suitable for further compression, and speed up computation using the learned weight coefficients. The method can be applied to compress an original pretrained DNN model. The method can also be used as an additional processing module to further compress a pruned DNN model.

Examples of unification regularization techniques are described below. Let 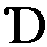 ={(x,y)} denote a data set where a target y is assigned to an input x. Let Θ={w} denote a set of weight coefficients of a DNN. The target of network training is to learn an optimal set of weight coefficients Θ* so that a target loss 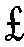 ( 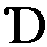 |Θ) can be minimized. For example, in some network pruning approaches, the target loss 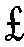 ( 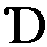 |Θ) has two parts, an empirical data loss 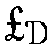 ( 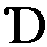 |Θ) and a sparsity-promoting regularization loss 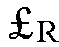 (Θ): 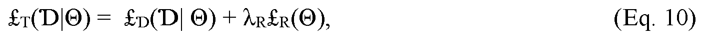 where λ_{R}≥0 is a hyperparameter balancing the contributions of the data loss and the regularization loss.

The sparsity-promoting regularization loss places regularization over the entire weight coefficients, and the resulting sparse weights have a weak relationship with the inference efficiency or computation acceleration. From another perspective, after pruning, the sparse weights can further go through another network training process where an optimal set of weight coefficients can be learned that can improve the efficiency of further model compression.

In some embodiments, a weight unification loss 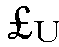 ( 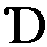 |Θ) given below can be optimized together with the original target loss: 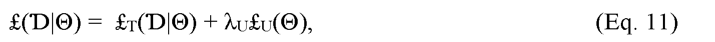 where λ_{U}≥0 is a hyperparameter to balance the contributions of the original training target and the weight unification. By jointly optimizing 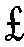 ( 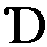 |Θ) of Eq. 11, the optimal set of weight coefficients can be obtained that can largely help the effectiveness of further compression. Also, the weight unification loss of Eq. 11 takes into consideration the underlying process of how the convolution operation is performed as a general matrix multiplication (GEMM) process, resulting in optimized weight coefficients that can largely accelerate computation. It is worth noting that the weight unification loss can be viewed as an additional regularization term to a general target loss, with (when λ_{R}>0) or without (when λ_{R}=0) general regularizations. Also, this method can be flexibly applied to any regularization loss 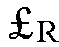 (Θ).

In an embodiment, the weight unification loss 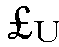 (Θ) further comprises the compression rate loss 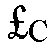 (Θ), the unification distortion loss 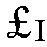 (Θ), and the computation speed loss 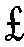 S(Θ):

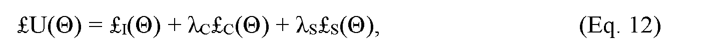

Detailed descriptions of these loss terms are described in later. For both the learning effectiveness and the learning efficiency, an iterative optimization process is further described. In the first step, parts of the weight coefficients satisfying the desired structure are fixed, and then in the second step, the non-fixed parts of the weight coefficients are updated by back-propagating the training loss. By iteratively conducting these two steps, more and more weights can be fixed gradually, and the joint loss can be gradually optimized effectively.

Moreover, in an embodiment, each layer is compressed individually, 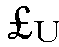 ( 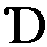 |Θ) can be further written as: 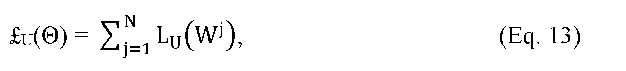 where L_{U}(W^{j}) is a unification loss defined over the j-th layer; N is the total number of layers where the quantization loss is measured; and Wj denotes the weight coefficients of the j-th layer. Again, since L_{U}(W^{j}) is computed for each layer independently, in the rest of the disclosure the script j is omitted without loss of generality.

In an embodiment, for each network layer, its weight coefficients W form a general 5-Dmension (5D) tensor with size (cᵢ, k₁, k₂, k₃, cₒ). The input of the layer is a 4-Dimension (4D) tensor A of size (hᵢ, wᵢ, dᵢ, cᵢ), and the output of the layer is a 4D tensor B of size (hₒ, wₒ, dₒ, cₒ). The sizes cᵢ, k₁, k₂, k₃, cₒ, hᵢ, wᵢ, dᵢ, hₒ, wₒ, dₒ are integer numbers greater or equal to 1. When any of the sizes cᵢ, k₁, k₂, k₃, cₒ, hᵢ, wᵢ, dᵢ, hₒ, wₒ, dₒ takes number 1, the corresponding tensor reduces to a lower dimension. Each item in each tensor is a floating number. Let M denote a 5D binary mask of the same size as W, where each item in M is a binary number 0/1 indicating whether the corresponding weight coefficient is pruned/kept. M is introduced to be associated with W to cope with the case where W is from a pruned DNN model where some connections between neurons in the network are removed from computation. When W is from the original unpruned pretrained model, all items in M take value 1. The output B is computed through the convolution operation 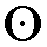 based on A, M, and W: $\begin{matrix}{B}_{l ′ , m ′ , n ′ , v} = {\sum }_{r = 1}^{{k}_{1}} {\sum }_{s = 1}^{{k}_{2}} {\sum }_{t}^{{k}_{3}} {\sum }_{u = 1}^{{c}_{i}} {M}_{u , r , s , t , v} {W}_{u , r , s , t , v} {A}_{u , l - \frac{{k}_{1} - 1}{2} + r , m - \frac{{k}_{2} - 1}{2} + s , n - \frac{{k}_{3} - 1}{2} + t} , \\ l = 1 , ⋯ , {h}_{i} , m = 1 , ⋯ , {w}_{i} , n = 1 , ⋯ , {d}_{i} , l ′ = 1 , ⋯ , {h}_{o} , \\ m ′ = 1 , ⋯ , {w}_{o} , n ′ = 1 , ⋯ , {d}_{o} , v = 1 , ⋯ , {c}_{o}\end{matrix}$ (Eq. 14)

The parameters hᵢ, wᵢ and dᵢ (h₀, wₒ and dₒ) are the height, weight, and depth of the input tensor A (output tensor B). The parameter cᵢ (cₒ) is the number of input (output) channel. The parameters k₁, k₂, and k₃ are the size of the convolution kernel corresponding to the height, weight, and depth axes, respectively. That is, for each output channel *v* = 1, ··· , *cₒ*, the operation described in Eq. 14 can be seen as a 4D weight tensor Wᵥ of size (cᵢ, k₁, k₂, k₃) convolving with the input A.

In an embodiment, the order of the summation operation in Eq. 14 can be changed. In the embodiment, the operation of Eq. 14 can be performed as follows. The 5D weight tensor is reshaped into a 3D tensor of size (cᵢ, cₒ, k) where k=k₁·k₂·k₃. The order of reshaped index along the k axis is determined by a reshaping algorithm in a reshaping process, which will be described in detail later.

In an embodiment, the desired structure of the weight coefficients is designed by taking into consideration two aspects. First, the structure of the weight coefficients is aligned with the underlying GEMM matrix multiplication process of how the convolution operation is implemented so that the inference computation of using the learned weight coefficients is accelerated. Second, the structure of the weight coefficients can help to improve the quantization and entropy coding efficiency for further compression.

In one embodiment, a block-wise structure is used for the weight coefficients in each layer in the 3D reshaped weight tensor. Specifically, the 3D tensor is partitioned into blocks of size (gᵢ, gₒ, gₖ), and all coefficients within the block are unified in an embodiment. Unified weights in a block are set to follow a pre-defined unification rule, e.g., all values are set to be the same so that one value can be used to represent the whole block in the quantization process which yields high efficiency.

There can be multiple rules of unifying weights, each associated with a unification distortion loss measuring the error introduced by taking this rule. For example, instead of setting the weights to be the same, the weights can be set to have the same absolute value while keeping their original signs.

Given this designed structure, during an iteration, the part of the weight coefficients to be fixed is first determined by taking into consideration the unification distortion loss, the estimated compression rate loss, and the estimated speed loss. Then, in the second step, the normal neural network training process is performed and the remaining un-fixed weight coefficients are updated through the back-propagation mechanism.

### 2. Workflow

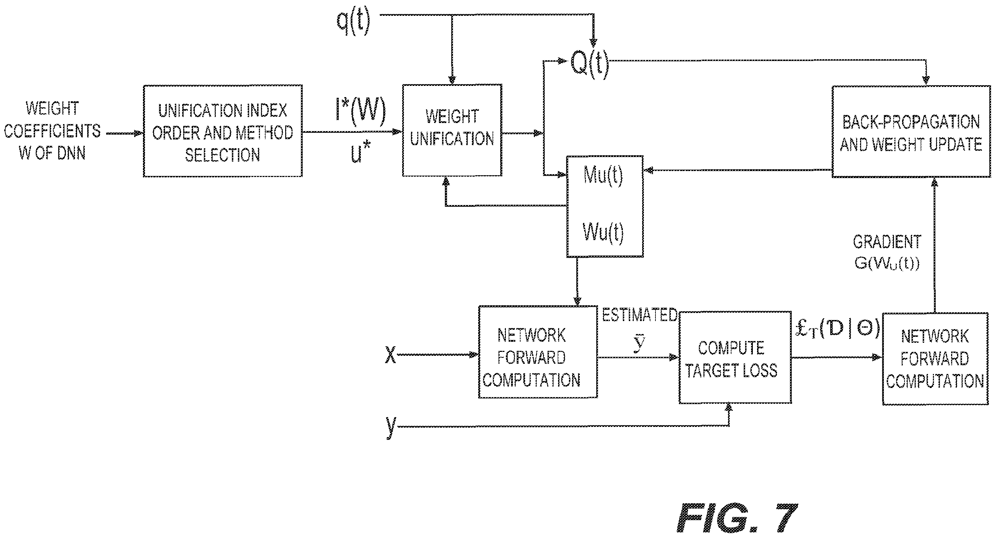

FIG. 7 shows the overall framework of the iterative retraining/finetuning process, which iteratively alternates two steps to optimize the joint loss of Eq. 11 gradually. Given a pre-trained DNN model with weight coefficients W and mask M, which can be either a pruned sparse model or an un-pruned non-sparse model, in the first step, the process can first determine the order of indexes I(W)=[i₀,...,iₖ] to reshape the weight coefficients W (and the corresponding mask M) through a Unification Index Order and Method Selection process, where k=k₁·k₂·k₃ is the reshaped 3D tensor of weights W.

Specifically, in an embodiment, the process can first partition the reshaped 3D tensor of weights W into super-blocks of size (gᵢ, gₒ, gₖ). Let S denote a super-block. I(W) is determined for each super-block S individually, based on the weight unification loss of the weight coefficients within the super-block S, i.e., based on the weight unification loss 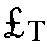 (Θ) of Eq. 12. The selection of the size of the super-blocks usually depends on the later compression methods. For example, in the embodiment, the process can choose super-blocks of size (64,64,k) to be consistent with the 3-Dimension Coding Tree Unit (CTU3D) used by a later compression process.

In an embodiment, each super-block S is further partitioned into blocks of size (dᵢ, dₒ, dₖ). Weight unification happens inside the blocks. For each super-block S, a weight unifier is used to unify the weight coefficients within the blocks of S. Let b denote a block in S, there can be different ways to unify weight coefficients in b. For example, the weight unifier can set all weights in b to be the same, e.g., the mean of all weights in b. In such a case, the L_{N} norm of the weight coefficients in b (e.g., L₂ norm as a variance of weights in b) reflects the unification distortion loss 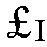 (b) of using the mean to represent the entire block.

Also, the weight unifier can set all weights to have the same absolute value, while keeping the original signs. In such a case, the L_{N} norm of the absolute of weights in b can be used to measure L_{I}(b). In other words, given a weight unifying method u, the weight unifier can unify weights in b using the method u with an associated unification distortion loss L_{I}(u,b). Then the process can compute the unification distortion loss 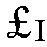 (u,S) of the entire super-block S by averaging L_{I}(u,b) across all blocks in S, i.e., L_{I}(u,S)=average_{b}(L_{I}(u,b)).

Similarly, the compression rate loss 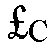 (u,S) of Eq. 12 reflects the compression efficiency of unifying weights in the super-block S using method u. For example, when all weights are set to be the same, only one number is used to represent the whole block, and the compression rate is r_{compression}= gᵢ·gₒ·gₖ. £c(u,S) can be defined as 1/r_{compression}.

The speed loss 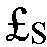 (u,S) in Eq. 12 reflects the estimated computation speed of using the unified weight coefficients in S with method u, which is a function of the number of multiplication operations in computation using the unified weight coefficients.

By now, for each possible way of reordering the indexes to generate the 3D tensor of weights W, and for each possible method u of unifying weights by the weight unifier, the process can compute the weight unification loss 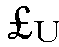 (u,S) of Eq. 12 based on 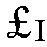 (u,S), 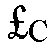 (u,S), 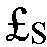 (u,S). The optimal weight unifying method u* and the optimal reordering indexes I*(W) can be selected whose combination has the smallest weight unification loss 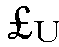 *(u,S). When k is small, the process can exhaustively search for the best I*(W) and u*. For large k, other methods can be used to find suboptimal I*(W) and u*. This disclosure does not put any restrictions on the specific ways of determining I*(W) and u*.

Once the order of indexes I*(W) and the weight unifying method u* are determined for every super-block S, the target turns to finding a set of updated optimal weight coefficients W* and the corresponding weight mask M* by iteratively minimizing the joint loss described in Eq. 11.

Specifically, for the t-th iteration, the process can have the current weight coefficients W(t-1) and mask M(t-1). Also, the process can maintain a weight unifying mask Q(t-1) throughout the training process. The weight unifying mask Q(t-1) has the same shape as W(t-1), which records whether a corresponding weight coefficient is unified or not. Then, a unified weight coefficients W_{U}(t-1) and a new unifying mask Q(t-1) are computed through a Weight Unification process.

In the Weight Unification process, the process can reorder the weight coefficients in S according to the determined order of index I*(W), and then rank the super-blocks based on their unification loss 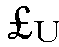 (u*,S) in accenting order. Given a hyperparameter q, the top q super-blocks are selected to be unified. And the weight unifier unifies the blocks in the selected super-blocks S using the corresponding determined method u*, resulting in a unified weight W_{U}(t-1) and weight mask M_{U}(t-1).

The corresponding entry in the unifying mask Q(t-1) is marked as being unified. In the embodiment, M_{U}(t-1) is different from M(t-1), where for a block having both pruned and unpruned weight coefficients, the originally pruned weight coefficients will be set to have a non-zero value again by the weight unifier, and the corresponding item in M_{U}(t-1) will be changed. For other types of blocks, M_{U}(t-1) will naturally remain unchanged.

Then in the second step, the process can fix the weight coefficients which are marked in Q(t-1) as being unified, and then update the remaining unfixed weight coefficients of W(t-1) through a neural network training process, resulting in updated W(t) and M(t).

Let 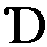 ={(x,y)} denote a training dataset, where D can be the same as the original dataset 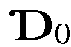 ={(x₀,y₀)} based on which the pre-trained weight coefficients W are obtained. D can also be a different dataset from 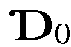 , but with the same data distribution as the original dataset D. In the second step, each input x is passed through the current network via a Network Forward Computation process using the current weight coefficients W_{U}(t-1) and mask M_{U}(t-1), which generates an estimated output y̅. Based on the ground-truth annotation y and the estimated output y̅, the target training loss 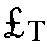 ( 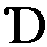 |Θ) in Eq. 11 can be computed through a Compute Target Loss process.

Then the gradient of the target loss G(W_{U}(t-1)) can be computed. The automatic gradient computing method used by deep learning frameworks such as Tensorflow or Pytorch can be used to compute G(W_{U}(t-1)). Based on the gradient G(W_{U}(t-1)) and the unifying mask Q(t-1), the non-fixed weight coefficients of W_{U}(t-1) and the corresponding mask M_{U}(t-1) can be updated through back-propagation using a Back Propagation and Weight Update process.

The retraining process is also an iterative process itself, which is marked by the dotted box in FIG. 7. Typically multiple iterations are taken to update the non-fixed parts of W_{U}(t-1) and the corresponding M(t-1), e.g., until the target loss converges. Then the system goes to the next iteration t, where given a new hyperparameter q(t), based on W_{U}(t-1), u* and I*(W), a new unified weight coefficients W_{U}(t), mask M_{U}(t), and the corresponding unifying mask Q(t) can be computed through the Weight Unification process.

It is noted that the order of indexes I(W)=[i₀,...,iₖ] to reorder the reshaped weight coefficients can take the trivial original order and therefore be optional and neglectable. In that case, the process can skip the process of reordering the reshaped weight coefficients.

The unification based parameter reduction methods disclosed herein provide the following technical advantages. The unification regularization targets at improving the efficiency of further compression of the learned weight coefficients, speeding up computation for using the optimized weight coefficients. This can significantly reduce the DNN model size and speed up the inference computation.

In addition, through the iterative retraining process, the methods can effectively maintain the performance of the original training target and pursue compression and computation efficiency. The iterative retraining process also gives the flexibility of introducing different losses at different times, making the system focus on different targets during the optimization process. Further, the methods can be generally applied to datasets with different data forms. The input/output data are general 4D tensors, which can be real video segments, images, or extracted feature maps.

### 3. Syntax Elements for Unification Based Parameter Reduction

In some embodiments, one or more syntax elements are employed for compressing a neural network model (e.g., a DNN model) using a weight unification based model parameter reduction method as well as for using the corresponding compressed neural network model.

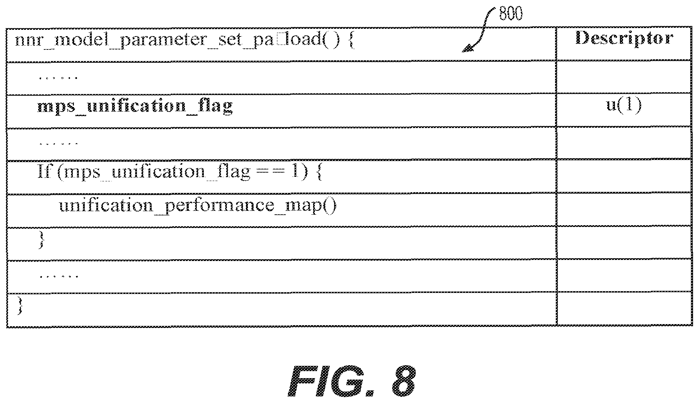

FIG. 8 shows an example syntax table (800) for unification based parameter reduction. The syntax table (800) includes a syntax element of a model level unification flag, denoted mpsunification _flag, in a payload section of a model parameter set transmitted in a bitstream. The mps_unification_flag can specify whether unification is applied to compressed data units that reference this model parameter set in the bitstream. The compressed data units may carry compressed data of a compressed neural network model in the bitstream.

When the mps_unification_flag is decoded and, for example, has a value (e.g., 1) indicating unification is applied, a syntax structure of a model level unification performance map, denoted unification_performance_map(), can be received in the model parameter set payload syntax section in the bitstream. In an embodiment, the unification_performance_map() in the model parameter set can specify a number of thresholds, reshaped tensor dimensions, super block, and block dimensions, unification thresholds, or the like, in a model level. In an embodiment, the unification_performance_map() can specify a mapping between different unification thresholds (applied in unification processes) and resulting neural inference accuracies.

In an example, the resulting accuracies are provided separately for different aspects or characteristics of the output of the neural network. For example, for a classifier neural network, each unification threshold is mapped to separate accuracies for each class, in addition to an overall accuracy that considers all classes. Classes can be ordered based on the neural network output order, i.e, the order specified during the training of the neural network.

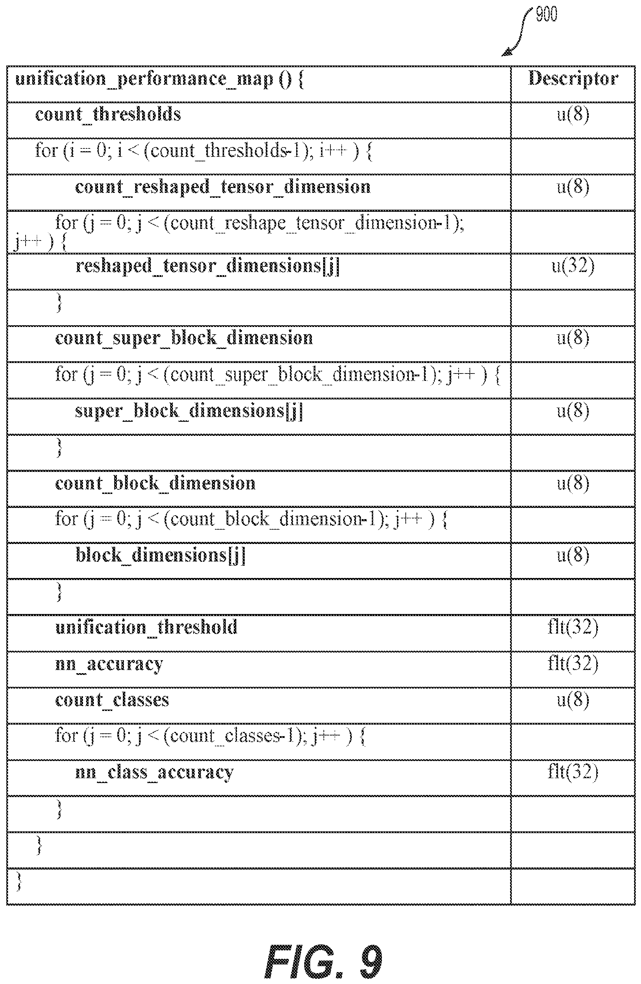

FIG. 9 shows an example of the syntax structure (900) of a unification performance map. In the structure (900), the syntax element count_thresholds specifies the number of unification thresholds. In an example, this number is non-zero. The syntax element count_reshaped_tensor_dimensions specifies a counter of how many dimensions are specified for reshaped tensor. For example, for a weight tensor reshaped to 3-dimensional tensor, count_dims is 3.

The syntax element reshaped_tensor_dimensions specifies an array or list of dimension values. For example, for a convolutional layer reshaped to 3-dimensional tensor, dim is an array or list of length 3. The syntax element count_super_block_dimensions specifies a counter of how many dimensions are specified. For example, for a 3-dimensional super block, count_dims is 3. The syntax element super_block_dimensions specifies an array or list of dimension values. For example, for a 3-dimensional super block, dim is an array or list of length 3, i.e., [64, 64, kernel_size]. The syntax element count_block_dimensions specifies a counter of how many dimensions are specified. For example, for a 3-dimensional block, count_dims is 3.

The syntax element block_dimensions specifies an array or list of dimension values. For example, for a 3-dimensional block, dim is an array or list of length 3, i.e., [2, 2, 2]. The syntax element unification_threshold specifies the threshold which is applied to tensor block to unify the absolute value of weights in this tensor block. The syntax element nn_accuracy specifies the overall accuracy of the neural network (e.g., classification accuracy by considering all classes).

The syntax element count_classes specifies a number of classes for which separate accuracies are provided for each unification threshold. The syntax element nn_class_accuracy specifies the accuracy for a certain class when a certain unification threshold is applied.

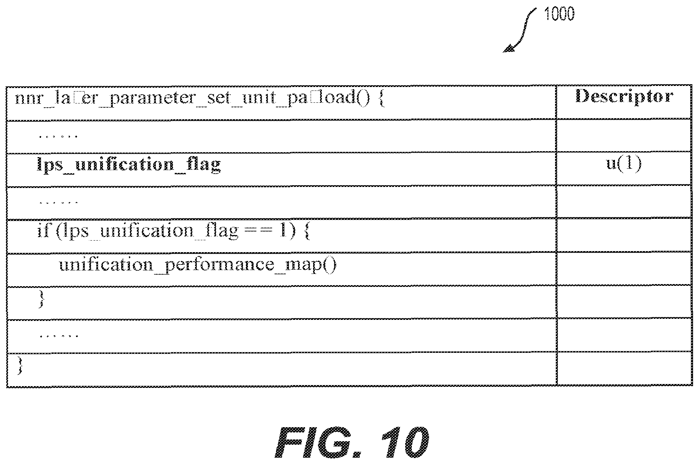

FIG. 10 shows another example syntax table (1000) for unification based parameter reduction. The syntax table (1000) shows a payload section of a layer parameter set transmitted in a bitstream. The layer parameter set includes a syntax element of a layer level unification flag, denoted lps unification flag. The lps_unification_flag can specify whether unification is applied to compressed data units that reference this layer parameter set in the bitstream. The compressed data units may carry compressed data of a layer of a compressed neural network model.

When the lps_unification_flag is decoded and, for example, has a value (e.g., 1) indicating unification is applied, a syntax structure of a layer level unification performance map, denoted unification_performance_map, can be received in the layer parameter set payload syntax section in the bitstream. In an embodiment, the unification_performance_map() in the layer parameter set can specify a number of thresholds, reshaped tensor dimensions, super block and block dimensions, unification thresholds, or the like, in a layer level.

In an embodiment, the unification_performance_map() in the layer parameter set can specify a mapping between different unification thresholds (applied in a layer level) and resulting neural inference accuracies. In an embodiment, the unification_performance_map() in the layer parameter set can have a similar structure as that in the model level as shown in FIG. 9.

In an example, both the mps_unification_flag in a model parameter set and the lps_unification_flag in a layer parameter set are signaled in a bitstream. For example, the value of the mps_unification_flag & lps_unification_flag is equal to 1. In such a scenario, the values of syntax elements in the unification_performance_map() in the layer parameter set are used in the compressed data units that reference this layer parameter set. In other words, the values of syntax elements in the unification_performance_map() in the layer parameter set override the values of syntax elements in the unification_performance_map() in model parameter set for a layer referencing the unification_performance_map() in the layer parameter set.

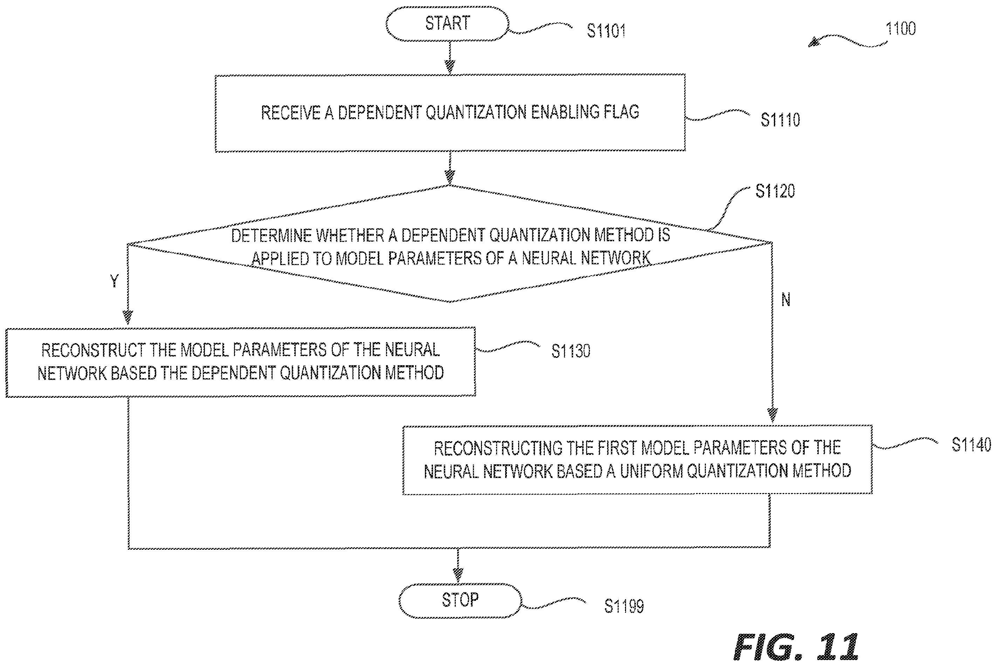

FIG. 11 shows a flow chart outlining a process (1100) according to an embodiment of the disclosure. The process (1100) can be used in a device, such as the electronic device (130) to decode (decompress) a bitstream corresponding to a compressed representation of a neural network. The process can start at (S1101) and proceed to (S1110).

At (S1110), a dependent quantization enabling flag can be received in the bitstream. For example, the dependent quantization enabling flag can be signaled at a model level, a layer level, a sublayer level, a 3-dimensional coding unit (CU3D) level, or a 3-dimensional coding tree unit (CTU3D) level. Accordingly, the dependent quantization flag can be applied to compressed data at different levels in the structure of the neural network.

At (S1120), whether a dependent quantization method is applied to respective model parameters of the neural network can be determined based on the dependent quantization enabling flag. For example, a value of 1 of the dependent quantization enabling flag can indicate the dependent quantization method is applied, while a value of 0 can indicate a uniform quantization method can be applied.

At (S1130), when the dependent quantization method is applied, the respective model parameters of the neural network can be reconstructed based on the dependent quantization method. For example, entropy decoding and inverse quantization operations can accordingly be performed using the dependent quantization method. The process (1100) can proceed to (S1199).

At (S1140), when the uniform quantization method is applied, the respective model parameters of the neural network can be reconstructed based on the uniform quantization method. For example, entropy decoding and inverse quantization operations can accordingly be performed using the uniform quantization method. The process (1100) can proceed to (S1199).

At (S1199), after the step of (S1130) or (S1140) is completed, the process (1100) can terminate.

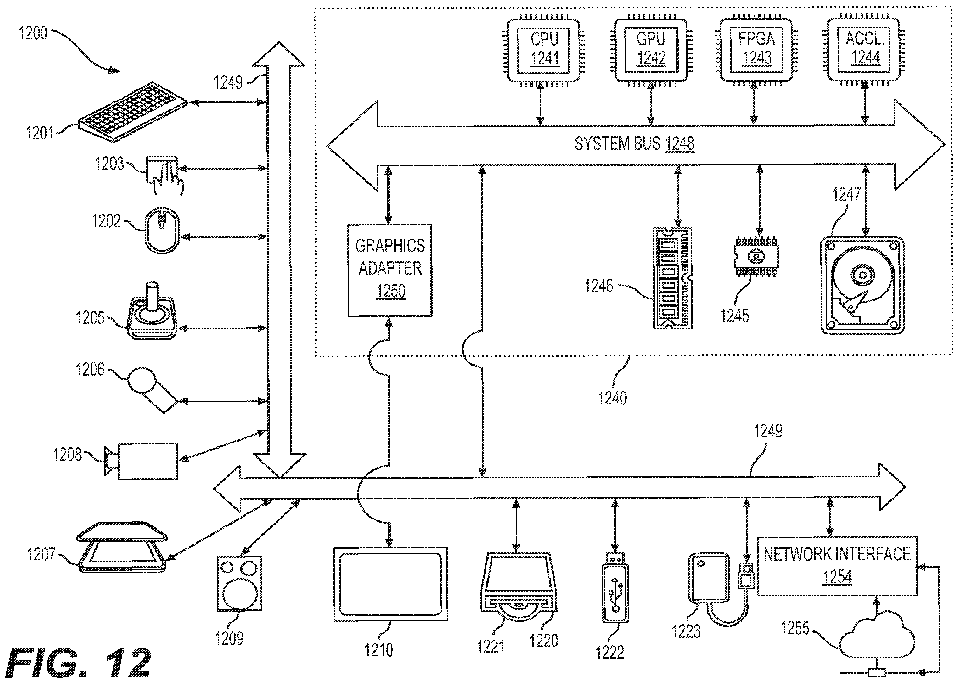

The techniques described above, can be implemented as computer software using computer-readable instructions and physically stored in one or more computer-readable media. For example, FIG. 12 shows a computer system (1200) suitable for implementing certain embodiments of the disclosed subject matter.

The computer software can be coded using any suitable machine code or computer language, that may be subject to assembly, compilation, linking, or like mechanisms to create code comprising instructions that can be executed directly, or through interpretation, micro-code execution, and the like, by one or more computer central processing units (CPUs), Graphics Processing Units (GPUs), and the like.

The instructions can be executed on various types of computers or components thereof, including, for example, personal computers, tablet computers, servers, smartphones, gaming devices, internet of things devices, and the like.

The components shown in FIG. 12 for a computer system (1200) are exemplary in nature and are not intended to suggest any limitation as to the scope of use or functionality of the computer software implementing embodiments of the present disclosure. Neither should the configuration of components be interpreted as having any dependency or requirement relating to any one or combination of components illustrated in the exemplary embodiment of a computer system (1200).

Computer system (1200) may include certain human interface input devices. Such a human interface input device may be responsive to input by one or more human users through, for example, tactile input (such as keystrokes, swipes, data glove movements), audio input (such as voice, clapping), visual input (such as gestures), olfactory input (not depicted). The human interface devices can also be used to capture certain media not necessarily directly related to conscious input by a human, such as audio (such as speech, music, ambient sound), images (such as scanned images, photographic images obtain from a still image camera), video (such as two-dimensional video, three-dimensional video including stereoscopic video).

Input human interface devices may include one or more of (only one of each depicted): keyboard (1201), mouse (1202), trackpad (1203), touch screen (1210), data-glove (not shown), joystick (1205), microphone (1206), scanner (1207), camera (1208).

Computer system (1200) may also include certain human interface output devices. Such human interface output devices may be stimulating the senses of one or more human users through, for example, tactile output, sound, light, and smell/taste. Such human interface output devices may include tactile output devices (for example tactile feedback by the touch-screen (1210), data-glove (not shown), or joystick (1205), but there can also be tactile feedback devices that do not serve as input devices), audio output devices (such as speakers (1209), headphones (not depicted)), visual output devices (such as screens (1210) to include CRT screens, LCD screens, plasma screens, OLED screens, each with or without touch-screen input capability, each with or without tactile feedback capability-some of which may be capable to output two dimensional visual output or more than three dimensional output through means such as stereographic output; virtual-reality glasses (not depicted), holographic displays and smoke tanks (not depicted)), and printers (not depicted).

Computer system (1200) can also include human accessible storage devices and their associated media such as optical media including CD/DVD ROM/RW (1220) with CD/DVD or the like media (1221), thumb-drive (1222), removable hard drive or solid state drive (1223), legacy magnetic media such as tape and floppy disc (not depicted), specialized ROM/ASIC/PLD based devices such as security dongles (not depicted), and the like.

Those skilled in the art should also understand that term "computer readable media" as used in connection with the presently disclosed subject matter does not encompass transmission media, carrier waves, or other transitory signals.

Computer system (1200) can also include an interface to one or more communication networks. Networks can for example be wireless, wireline, optical. Networks can further be local, wide-area, metropolitan, vehicular and industrial, real-time, delay-tolerant, and so on. Examples of networks include local area networks such as Ethernet, wireless LANs, cellular networks to include GSM, 3G, 4G, 5G, LTE and the like, TV wireline or wireless wide area digital networks to include cable TV, satellite TV, and terrestrial broadcast TV, vehicular and industrial to include CANBus, and so forth. Certain networks commonly require external network interface adapters that attached to certain general purpose data ports or peripheral buses (1249) (such as, for example USB ports of the computer system (1200)); others are commonly integrated into the core of the computer system (1200) by attachment to a system bus as described below (for example Ethernet interface into a PC computer system or cellular network interface into a smartphone computer system). Using any of these networks, computer system (1200) can communicate with other entities. Such communication can be uni-directional, receive only (for example, broadcast TV), uni-directional send-only (for example CANbus to certain CANbus devices), or bi-directional, for example to other computer systems using local or wide area digital networks. Certain protocols and protocol stacks can be used on each of those networks and network interfaces as described above.

Aforementioned human interface devices, human-accessible storage devices, and network interfaces can be attached to a core (1240) of the computer system (1200).

The core (1240) can include one or more Central Processing Units (CPU) (1241), Graphics Processing Units (GPU) (1242), specialized programmable processing units in the form of Field Programmable Gate Areas (FPGA) (1243), hardware accelerators for certain tasks (1244), and so forth. These devices, along with Read-only memory (ROM) (1245), Random-access memory (1246), internal mass storage such as internal non-user accessible hard drives, SSDs, and the like (1247), may be connected through a system bus (1248). In some computer systems, the system bus (1248) can be accessible in the form of one or more physical plugs to enable extensions by additional CPUs, GPU, and the like. The peripheral devices can be attached either directly to the core's system bus (1248), or through a peripheral bus (1249). Architectures for a peripheral bus include PCI, USB, and the like.

CPUs (1241), GPUs (1242), FPGAs (1243), and accelerators (1244) can execute certain instructions that, in combination, can make up the aforementioned computer code. That computer code can be stored in ROM (1245) or RAM (1246). Transitional data can be also be stored in RAM (1246), whereas permanent data can be stored for example, in the internal mass storage (1247). Fast storage and retrieve to any of the memory devices can be enabled through the use of cache memory, that can be closely associated with one or more CPU (1241), GPU (1242), mass storage (1247), ROM (1245), RAM (1246), and the like.

The computer readable media can have computer code thereon for performing various computer-implemented operations. The media and computer code can be those specially designed and constructed for the purposes of the present disclosure, or they can be of the kind well known and available to those having skill in the computer software arts.

As an example and not by way of limitation, the computer system having architecture (1200), and specifically the core (1240) can provide functionality as a result of processor(s) (including CPUs, GPUs, FPGA, accelerators, and the like) executing software embodied in one or more tangible, computer-readable media. Such computer-readable media can be media associated with user-accessible mass storage as introduced above, as well as certain storage of the core (1240) that are of non-transitory nature, such as core-internal mass storage (1247) or ROM (1245). The software implementing various embodiments of the present disclosure can be stored in such devices and executed by core (1240). A computer-readable medium can include one or more memory devices or chips, according to particular needs. The software can cause the core (1240) and specifically the processors therein (including CPU, GPU, FPGA, and the like) to execute particular processes or particular parts of particular processes described herein, including defining data structures stored in RAM (1246) and modifying such data structures according to the processes defined by the software. In addition or as an alternative, the computer system can provide functionality as a result of logic hardwired or otherwise embodied in a circuit (for example: accelerator (1244)), which can operate in place of or together with software to execute particular processes or particular parts of particular processes described herein. Reference to software can encompass logic, and vice versa, where appropriate. Reference to a computer-readable media can encompass a circuit (such as an integrated circuit (IC)) storing software for execution, a circuit embodying logic for execution, or both, where appropriate. The present disclosure encompasses any suitable combination of hardware and software.

### Appendix: Acronyms

DNN: Deep Neural Network
NNR: Coded Representation of Neural Network
CTU: Coding Tree Unit
CTU3D: 3-Dimension Coding Tree Unit
CU: Coding Unit
CU3D: 3-Dimension Coding Unit
RD: Rate-Distortion
VVC: Versatile Video Coding

## Claims

1. A computer-implemented method of neural network decoding at a decoder (121), comprising:
receiving a first plurality of sublayers of coefficients of a layer of a neural network in a bitstream of a compressed representation of the neural network, wherein each sublayer is selected from scaling factors, biases, and batchnorm parameters;
receiving a second sublayer of weight coefficients of the layer of the neural network in the bitstream,
**characterised in that**,
the first plurality of sublayers is received before the second sublayers, and the method further comprises:
reconstructing the first plurality of sublayers of coefficients before reconstructing the second sublayer of weight coefficients;
merging the first plurality of sublayers of coefficients and the second sublayer that have been reconstructed to generate a combined tensor of coefficients; and
performing a one-time processing over source data from a layer prior to the layer during an inference process.

2. The method of claim 1, wherein the first plurality of sublayers of coefficients includes a sublayer of scaling factor coefficients, a sublayer of bias coefficients, or one or more sublayers of batch-normalization coefficients, and the coefficients of the first plurality of sublayers are represented using quantized or unquantized values.

3. The method of claim 1, wherein the layer of the neural network is a convolutional layer or a fully connected layer.

4. The method of claim 1, further comprising:
determining a decoding sequence of the first and second sublayers based on structure information of the neural network transmitted separately from the bitstream of the compressed representation of the neural network.

5. The method of claim 1, further comprising:
receiving one or more flags indicating whether the first sublayers are available in the layer of the neural network.

6. The method of claim 1, further comprising:
inferring a 1-dimensional tensor as a bias or local scaling tensor corresponding to one of the first sublayers of coefficients based on structure information of the neural network.

7. The method of claim 1, further comprising:
receiving reconstructed weight coefficients belonging to a portion of the second sublayer of weight coefficients as an input to the inference process while the remaining of the second sublayer of weight coefficients are still being reconstructed; and
performing matrix multiplication of the combined tensor of coefficients and the received reconstructed weight coefficients during the inference process.

## Patentansprüche

1. Ein computerimplementiertes Verfahren zum Decodieren eines neuronalen Netzes an einem Decoder (121), umfassend:
Empfangen einer ersten Mehrzahl von Unterschichten von Koeffizienten einer Schicht eines neuronalen Netzes in einem Bitstrom einer komprimierten Darstellung des neuronalen Netzes, wobei jede Unterschicht aus Skalierungsfaktoren, Bias-Werten und Batchnorm-Parametern ausgewählt ist;
Empfangen einer zweiten Unterschicht von Gewichtskoeffizienten der Schicht des neuronalen Netzes in dem Bitstrom,
**dadurch gekennzeichnet, dass**
die erste Mehrzahl von Unterschichten vor den zweiten Unterschichten empfangen wird und das Verfahren ferner umfasst:
Rekonstruieren der ersten Mehrzahl von Unterschichten von Koeffizienten vor dem Rekonstruieren der zweiten Unterschicht von Gewichtskoeffizienten;
Zusammenführen der ersten Mehrzahl von Unterschichten von Koeffizienten und der zweiten Unterschicht, die rekonstruiert worden sind, um einen kombinierten Tensor von Koeffizienten zu erzeugen; und
Durchführen einer einmaligen Verarbeitung an Quelldaten aus einer der Schicht vorhergehenden Schicht während eines Inferenzprozesses.

2. Verfahren nach Anspruch 1, wobei die erste Mehrzahl von Unterschichten von Koeffizienten eine Unterschicht von Skalierungsfaktorkoeffizienten, eine Unterschicht von Bias-Koeffizienten oder eine oder mehrere Unterschichten von Batch-Normalisierungskoeffizienten umfasst und die Koeffizienten der ersten Mehrzahl von Unterschichten unter Verwendung quantisierter oder nicht quantisierter Werte dargestellt werden.

3. Verfahren nach Anspruch 1, wobei die Schicht des neuronalen Netzes eine Faltungsschicht oder eine vollständig verbundene Schicht ist.

4. Verfahren nach Anspruch 1, ferner umfassend:
Bestimmen einer Decodierreihenfolge der ersten und zweiten Unterschichten basierend auf Strukturinformationen des neuronalen Netzes, die separat von dem Bitstrom der komprimierten Darstellung des neuronalen Netzes gesendet werden.

5. Verfahren nach Anspruch 1, ferner umfassend:
Empfangen eines oder mehrerer Flags, die angeben, ob die ersten Unterschichten in der Schicht des neuronalen Netzes verfügbar sind.

6. Verfahren nach Anspruch 1, ferner umfassend:
Ableiten eines 1-dimensionalen Tensors als einen Bias-Tensor oder lokalen Skalierungstensor, der einer der ersten Unterschichten von Koeffizienten entspricht, basierend auf Strukturinformationen des neuronalen Netzes.

7. Verfahren nach Anspruch 1, ferner umfassend:
Empfangen rekonstruierter Gewichtskoeffizienten, die zu einem Abschnitt der zweiten Unterschicht von Gewichtskoeffizienten gehören, als eine Eingabe für den Inferenzprozess, während der Rest der zweiten Unterschicht von Gewichtskoeffizienten noch rekonstruiert wird; und
Durchführen einer Matrixmultiplikation des kombinierten Tensors von Koeffizienten und der empfangenen rekonstruierten Gewichtskoeffizienten während des Inferenzprozesses.

## Revendications

1. Procédé mis en œuvre par ordinateur de décodage de réseau neuronal au niveau d'un décodeur (121), comprenant :
la réception d'une première pluralité de sous-couches de coefficients d'une couche d'un réseau neuronal dans un train de bits d'une représentation compressée du réseau neuronal, dans lequel chaque sous-couche est sélectionnée parmi des facteurs de mise à l'échelle, des biais et des paramètres batchnorm ;
la réception d'une deuxième sous-couche de coefficients de poids de la couche du réseau neuronal dans le train de bits,
**caractérisé en ce que**,
la première pluralité de sous-couches est reçue avant les deuxièmes sous-couches, et le procédé comprend en outre :
la reconstruction de la première pluralité de sous-couches de coefficients avant la reconstruction de la deuxième sous-couche de coefficients de poids ;
la fusion de la première pluralité de sous-couches de coefficients et de la deuxième sous-couche qui ont été reconstruites pour générer un tenseur combiné de coefficients ; et
l'exécution d'un traitement unique sur des données sources provenant d'une couche antérieure à la couche au cours d'un processus d'inférence.

2. Le procédé selon la revendication 1, dans lequel la première pluralité de sous-couches de coefficients comprend une sous-couche de coefficients de facteurs de mise à l'échelle, une sous-couche de coefficients de biais, ou une ou plusieurs sous-couches de coefficients de normalisation par lots, et les coefficients de la première pluralité de sous-couches sont représentés à l'aide de valeurs quantifiées ou non quantifiées.

3. Le procédé selon la revendication 1, dans lequel la couche du réseau neuronal est une couche convolutionnelle ou une couche entièrement connectée.

4. Le procédé selon la revendication 1, comprenant en outre :
la détermination d'une séquence de décodage des première et deuxième sous-couches sur la base d'informations de structure du réseau neuronal transmises séparément du train de bits de la représentation compressée du réseau neuronal.

5. Le procédé selon la revendication 1, comprenant en outre :
la réception d'un ou plusieurs indicateurs indiquant si les premières sous-couches sont disponibles dans la couche du réseau neuronal.

6. Le procédé selon la revendication 1, comprenant en outre :
l'inférence d'un tenseur unidimensionnel en tant que tenseur de biais ou de mise à l'échelle locale correspondant à l'une des premières sous-couches de coefficients sur la base d'informations de structure du réseau neuronal.

7. Le procédé selon la revendication 1, comprenant en outre :
la réception de coefficients de poids reconstruits appartenant à une partie de la deuxième sous-couche de coefficients de poids en tant qu'entrée du processus d'inférence tandis que le reste de la deuxième sous-couche de coefficients de poids est encore en cours de reconstruction ; et
l'exécution d'une multiplication matricielle du tenseur combiné de coefficients et des coefficients de poids reconstruits reçus au cours du processus d'inférence.
